# NEW EUROPEAN PATENT SPECIFICATION

(11) **EP 2 082 413 B2**
(45) Date of publication and mention of the opposition decision: **23.02.2022**
(45) Mention of the grant of the patent: 24.12.2014
(21) Application number: 07817401.8
(22) Date of filing: 15.11.2007
(51) Int. Cl.: H01J 37/14, H01J 37/141, H01J 37/244, H01J 37/28

(54) **SCANNING ELECTRON MICROSCOPE**
RASTERELEKTRONENMIKROSKOP
MICROSCOPE ÉLECTRONIQUE À BALAYAGE

(30) Priority: 16.11.2006 CZ 20060721
(43) Date of publication of application: 29.07.2009
(73) Proprietor: Tescan, S.r.O., 623 00 Brno (CZ)
(72) Inventor: JIRUSE, Jaroslav, 678 01 Blansko (CZ); LOPOUR, Filip, 623 00 Brno (CZ)
(74) Representative: Kendereski, Dusan
(86) International application number: PCT/CZ2007/000105
(87) International publication number: WO 2008/058491

(56) References cited:
- EP-A- 0 592 899
- EP-A- 1 045 426
- EP-A- 1 120 809
- JP-A- 5 047 335
- JP-A- 54 137 977
- JP-A- 59 086 145
- US-A1- 2002 024 014
- US-A1- 2003 150 991
- Kruit, P.: "Magnetic Through-the -lens Detection in Electron Microscopy and Spectroscopy", Part 1: Advances in Optical and Electron Microscopy, vol. 12, 1991, pages 93-137,
- Aton, T. et al: "Characteristics of a virtual immersion lens spectrometer for electron beam testing", J. Vac. Sci. Technol., vol. B6, no. 6, 1988,

## Description

### Field of the Invention

Present invention deals with the field of scanning electron microscopy with high resolution and wide field of view.

### Description of the Prior Art

One of methods how to increase resolution of a scanning electron microscope is to shorten the working distance between objective and specimen. In traditional designs of microscopes such distance is limited by the fact that the secondary electron detector is located beside the objective and the specimen, in height typically between them. For too short working distances the signal for detector is no longer sufficient.

Known solutions overcome the mentioned disadvantage by placing the secondary electron detector either directly into the objective or above it. This allows to shorten the working distance without loss of signal. For instance, US patent No. 4,831,266 or US patent No. 5,387,793 describe such solutions with single conventionally shaped lens or single immersion lens. Both arrangements, however, do not allow to work in various display modes, see below. In addition, the solution mentioned as second has the disadvantage of considerably limited field of view because the scanning coils are located as far as above the objective body and detection device, which results in narrow scanning angle.

On the contrary, conventionally designed microscopes using objective consisting of two lenses allow using of multiple display modes, for example display by the first lens for high resolution, display by the second lens for great depth of focus and wide field of view, or combination of both. Such conventional microscopes are manufactured for many years already for instance by Tescan. As already mentioned above, their disadvantage is a loss of signal at short working distances.

Solution described by the US patent 6,894,277 tries to combine both approaches by using objective with two lenses and secondary electron detector located above the objective, thus allowing operation at short working distances and choosing different displays by the first and second lens, or their combination. Disadvantage of this arrangement, however, is relatively narrow field of view because the scanning coils are placed above both lenses of the objective and therefore the scanning angle is narrow. Another disadvantage is that in order to ensure operation of the device, the specimen must be connected to negative potential, which limits usability of the microscope.

US patent No. 5,578,822 also uses double lenses in the objective but the first is a single polepiece and the other is a double polepiece lens. Single polepiece lens, however, causes problems when displaying magnetic specimens because the lens's magnetic field reaches up to the specimen and the specimen deforms it. Moreover, due to the shape of its magnetic field such single polepiece lens allows secondary electron detection only in narrow field of view (the patent mentions 0.1 mm), thus limiting possible combined using of both lens of the microscope for wide field-of-view display.

Japanese patent JP 05 047335A also uses double lenses of conventional shape in the objective but with semispherical grids to shield the voltage of the secondary electron detector. These grids, however, have no effect on the resolving power of the objective lens. They are placed well above the gap of the first lens and well bellow of the gap of the second lens, thus the field along the axis in either gap is not substantially influenced and the resolution remains the same whether the grids are present or not.

### Summary of the Invention

Disadvantages mentioned above are eliminated by a scanning electron microscope according to claim 1. Electrode in this configuration accelerates primary electrons passing through the gap between the polepieces of the first double polepiece lens that implies reduced optical aberrations and so better resolution of the scanning electron microscope.

Another advantage of the scanning electron microscope according to claim 1 is that it allows to operate at short working distances using various display modes and the specimen does not necessarily need negative charging. For instance, it is possible to display by the first double polepiece lens, closer to the specimen, at very short working distances for high resolution; also it is possible to display by the second double polepiece lens at longer working distances for wider field of view and greater depth of focus; also it is possible to combine display of both double polepiece lenses, for example the second double polepiece lens may be focused to infinity (parallel beam) and the first double polepiece lens may be focused on the specimen; etc.

In addition, this arrangement has the advantage that scanning system is placed between both double polepiece lenses, i.e. closer to the specimen, thus increasing the field of view.

Further advantages may be derived from depending claims.

### Brief Description of the Drawings

Fig. 1 shows possible embodiment of a microscope according to this invention.
Fig. 2 shows another possible embodiment of a microscope.
Fig. 3 shows yet another possible embodiment of a microscope.
Fig. 4 shows yet another possible embodiment of a microscope.

### Description of Preferred Embodiments

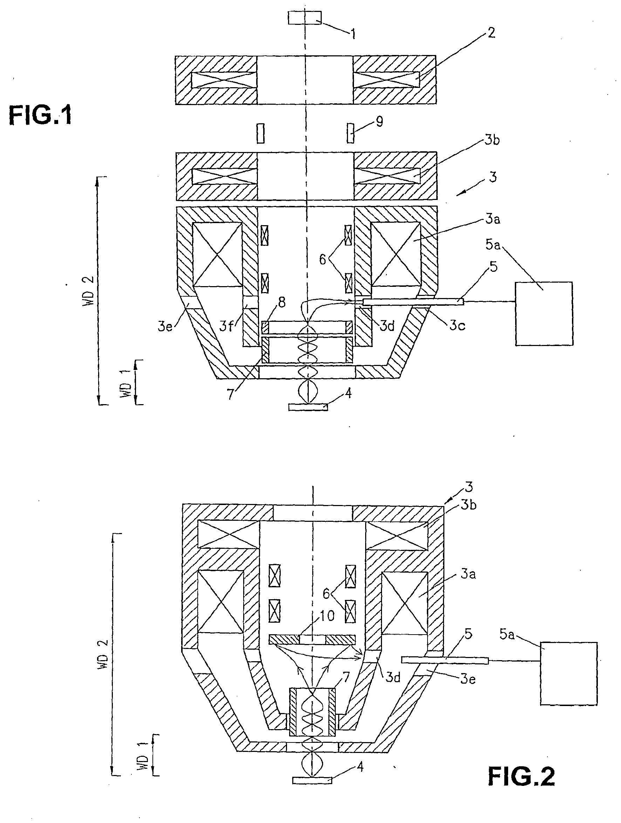

Fig. 1 shows schematic section of scanning electron microscope where the source 1 emits primary electrons accelerated to kinetic energy typically 0.5 - 50 keV, which pass through condenser 2 and are focused by magnetic objective 3 on specimen 4. Source 1 may, for instance, be a field-emission or thermo-emission gun and condenser 2 may have arbitrary convenient shape. Another part of the scanning electron microscope is a scanning system 6, which ensures scanning of the primary electron beam on the surface of the specimen. It may for example consist, as shown in fig. 1, of two-stage scanning coils. In given example, stigmators 9 used for correction of aberrations are also inserted between condenser 2 and magnetic objective 3. These stigmators 9 may also be located in other suitable position, for example inside the magnetic objective 3.

Magnetic objective 3 consists of the first double polepiece lens 3a with center at the first working distance WD1 from the specimen 4 and of the second double polepiece lens 3b with center at the second working distance WD2 from the specimen 4. Both lenses are conventionally shaped, i.e. they have two polepieces, as already mentioned. Two lenses allow to operate in various display modes. For instance, it is possible to display by the first double polepiece lens 3a at very short working distances for high resolution; also it is possible to display by the second double polepiece lens 3b at longer working distances for wider field of view and greater depth of focus; also it is possible to combine display of both lenses, for example to focus the second double polepiece lens 3b to infinity (parallel beam) and to focus the first double polepiece lens 3a on the specimen; etc.

In order to improve detection of secondary electrons an electrode 7, connected to source of positive, advantageously variable voltage, is placed in the magnetic objective 3. It is typically located above the external polepiece of the first double polepiece lens 3a, or it may cover first double polepiece lens 3a and partially extend to the gap between its polepieces. Secondary electrons emitted from the specimen 4 after incidence of the primary electron beam are attracted into the magnetic objective 3 by means of electrode 7. Both the magnetic objective 3 and specimen 4 are grounded and the electrode 7 has positive voltage of hundreds volts, for example 300 V. The specimen 4 may also be connected to source of negative voltage, nevertheless the method of detection of secondary electrons described below remains unchanged. If display by the first double polepiece lens 3a is activated, secondary electrons, which entered into the gap between the polepieces of the first double polepiece lens 3a, are focused by its magnetic field and continue moving upwards in spiral motion along the optical axis. Secondary electron detector 5 is located from side and protruded by the first bore 3c and the second bore 3d created in the polepieces of the first double polepiece lens 3a. Detector 5 may for example consist of scintillation crystal, light guide and photomultiplier. The scintillation crystal at the end of the detector 5 is connected to positive voltage, roughly 10 kV, which attracts secondary electrons to the detector 5, as shown schematically in fig. 1. Signal from the detector 5 is processed and displayed by terminal device 5a, such as CRT screen (Cathode Ray Tube).

Kinetic energy of secondary electrons emitted by the specimen 4 is in units or maximum in tens of eV. After passing through the electrode 7 they are accelerated by the electrode's voltage and subsequently, by influence of grounded walls of the magnetic objective 3, they are retarded to their original kinetic energy. When the secondary electrons reach the second bore 3d with detector 5 they sense its voltage and they are accelerated towards the detector 5. Field intensity of the detector 5 may be regulated by the distance of the end of the detector 5 from the optical axis or by its voltage. In case that geometric dimensions of the magnetic objective 3 do not allow sufficient distance between electrode 7 and the detector 5, i.e. the electrode's 7 field would be too strong at the optical axis in point facing the detector 5, it is still possible to insert the retarding electrode 8 between the electrode 7 and the plane of the second bore 3d, which shields off the electrode 7, e.g. by application of negative low voltage or by narrowing the internal diameter, but in such a manner, which will not limit the scanning of the primary electron beam on the specimen 4; in such a case the retarding electrode 8 may even be grounded and shaped as an aperture.

The first and second bores 3c and 3d in polepieces, which are used for the secondary electron detector 5, cause rotational asymmetry of the magnetic flux through the magnetic objective 3 and therefore also optical aberrations. For construction purposes the bore 3c may have different dimensions than bore 3d and both may be located in slightly different height. For compensation of the caused aberrations to negligible level it is possible to drill to the polepieces of the first double polepiece lens 3a of the magnetic objective 3 more bores in such a manner that at least one third bore 3e is created in the external polepiece and at least one follow-up fourth bore 3f is created in the internal polepiece. The third bores 3e have identical shape and size as the first bore 3c and their number, including the first bore 3c, is *n*. The fourth bores 3f have analogically identical shape and size as the second bore 3d and their number, including the second bore 3d, is *m.* Numbers *n* and *m* are even numbers and all bores 3c, 3e in the external polepiece as well as all bores 3d, 3f in the internal polepiece are distributed symmetrically around the optical axis of the magnetic objective 3. In addition, in this case where number of bores is even and they are distributed symmetrically it is also possible to use some of additional bores to accommodate other detectors of signals emitted by the specimen 4, for example backscattered electron detector, cathodoluminescence detector, X-ray detector, etc., which are placed on a pull-out device. When the secondary electron detector 5 is in function, these extra detectors are in retracted position and they do not extend from the internal polepiece of the first double polepiece lens 3a. When these detectors are to be used, they are extended into the area of the optical axis and the secondary electron detector 5 is switched off. This option is advantageous because it allows to record signals from secondary or backscattered electrons or cathodoluminescence or X-ray radiation at the same working distance.

Voltage applied to the electrode 7 may be exploited also for additional increase of the microscope's resolution, especially for lower values of kinetic energy of primary electrons. In this case, instead of the original extraction voltage 300 V, high voltage of roughly 1-10 kV will be used. For instance, if the voltage applied to the electrode 7 is 3 kV and the kinetic energy of primary electrons is 1 keV when they enter the magnetic objective 3, the primary electrons are accelerated and pass through the gap between the polepieces with the energy of 4 keV. This decreases aberrations and the microscope's resolution is better than it would be in case if the electrons would have been passing the gap between the polepieces with the energy of 1 keV only. When passing through the external (or bottom) polepiece, the primary electrons are again retarded and they are incident on the specimen 4 with their original energy of 1 keV. Optimum voltage applied to the electrode 7 varies for various kinetic energies of primary electrons. When the energy increases, however, the difference between the microscope's resolution with or without the high voltage applied to the electrode 7 keeps decreasing. The effect of retarding the primary electrons incident on the specimen 4 may be further increased by connecting the specimen 4 to negative voltage of about (-1)-(-10) kV. In such a case, the electrode 7 may reach up to the end of the external (bottom) polepiece because the primary electrons are being retarded by voltage of the specimen 4.

In case the second double polepiece lens 3b is used for displaying, the voltage applied to the electrode 7 does not need to be optimized according to the energy of the primary electrons and only low voltages will be sufficient to attract the secondary electrons into the magnetic objective 3.

In case both the first and second double polepiece lenses 3a and 3b are used for displaying in combination, the voltage applied to the electrode 7 may be optimized according to the excitation of the first double polepiece lens 3a.

It is advantageous when the whole secondary electron detection system, i.e. electrode 7, detector 5, and possible retarding electrode 8, are located below the scanning system 6. The scanning system 6 is in fact set to deflect the primary electron beam with the energy in the level of keV. On the other side, the energy of secondary electrons is in units or tens of eV and therefore, when passing the same scanners, they would be deflected from the optical axis much more, which would result in considerable technical problems with their detection. It is technically advantageous to deflect the secondary electrons towards the detector 5 yet below the scanning system 6 where they still are concentrated relatively close to the optical axis. However, it is still possible to use the invention in opposite arrangement of the detector 5 placed above the scanning system 6.

Fig. 2 shows the second example of the embodiment. In this case the part of the microscope above the objective, i.e. the source of electrons and the condensers, is omitted. Magnetic objective 3 again consists of the first double polepiece lens 3a at the first working distance WD1 and of the second double polepiece lens 3b at the second working distance WD2, which in this case have their magnetic circuits interconnected. In this case the retarding electrode 8 is omitted. Primary electron beam is again focused by the magnetic objective 3 on the specimen 4 and the scanning system 6 provides the beam's scanning on the surface of the specimen 4. Properties of displaying are the same as described in the preceding example.

The secondary electrons are again attracted into the magnetic objective 3 and accelerated by the electrode 7. This time, however, they fall onto the target 10 where they emit tertiary electrons, which are intercepted by the detector 5 and its signal is displayed by the terminal device 5a. Surface of the target 10 is made of suitable material, which has sufficiently high emissivity of electrons. Heavy elements with atomic number higher than 20 are suitable.

As one may see in this example, the first or the second bore, 3c or 3d respectively, for the secondary electron detector 5 may be drilled also in beveled part of cones of polepieces and they do not need to be exactly coaxial.

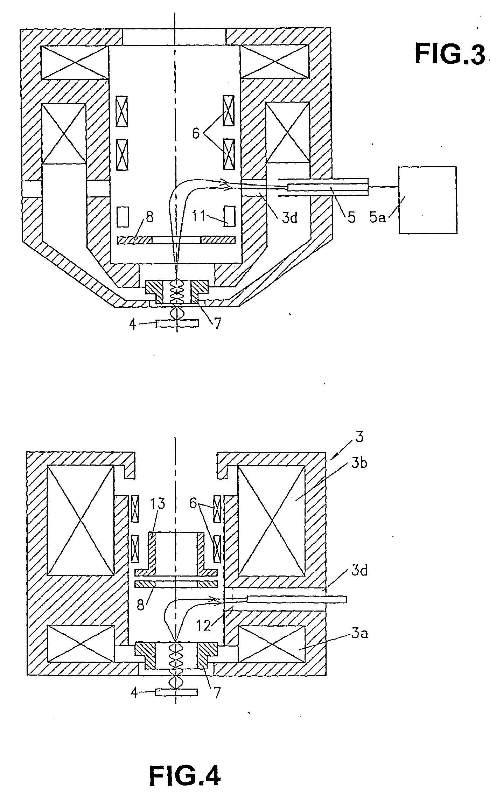

Examples of embodiments given above have a theoretical disadvantage that the field of the detector 5 reaches up to the optical axis and therefore it causes optical defects of the beam of primary electrons. In practice, such optical defects may be kept at negligible level because the field of the detector 5 in the vicinity of the optical axis needs to be only as strong as it is necessary to deflect the secondary electrons with energy in units of eV, which means the deflection of primary electrons with energy in thousands of eV will be small. Fig. 3 shows an example of yet another embodiment, which solves this theoretical disadvantage. Between the electrode 7 and the plane of the second bore 3d is inserted a device 11 used for creating a crossed adjustable magnetic and electrostatic field, in a direction orthogonal to the optical axis of the magnetic objective 3, so-called Wien filter. Electrostatic field is orthogonal to the magnetic field and its size is adjusted to ensure that, for given velocity of primary electrons, the electric force is equal to the magnetic force but oriented in the opposite direction. Primary electron beam therefore is not deflected by the Wien filter. On the contrary, the secondary electrons emitted from the specimen 4 travel in opposite direction and thus the electric as well as the magnetic force are oriented correspondingly and deflect the secondary electrons to the detector 5. As opposed to the previous examples, in this case the field of the detector 5 does not need to reach significantly up to the optical axis. Between the Wien filter and the electrode 7 the secondary electrons may again be retarded by retarding electrode 8, therefore the Wien filter may produce weaker field to deflect the secondary electrons towards the detector 5.

Fig. 4 shows another example of embodiment. This time, the retarding electrode 8, connected to negative voltage or grounded, is placed above the plane of the detector 5. Secondary electrons emitted from the specimen 4 and accelerated by the electrode 7 are retarded by the retarding electrode 8 in the area of the plane of the second bore 3d and attracted by the field of the detector 5. Fig. 4 shows also another way of regulation of the detector's 5 field intensity in the vicinity of the optical axis than only by changing the distance of the detector's 5 front from the optical axis or its voltage: by inserting the deflector 12 connected to suitable positive regulation voltage, for example roughly 200 V. The deflector 12 may be formed by a grid or a clamp-shaped electrode. To ensure that the field of retarding electrode 8 does not undesirably affect the scanning system 6, it may be shielded by grounded clamp 13. In this example one may also see that the shape of magnetic objective 3 is not limited to cone-shaped design only, i.e. it may be cylindrical and the coil winding of the first double polepiece lens 3a may be slipped under the secondary electron detector 5.

Given examples of use are purely illustrative and may be combined in various ways, for instance the shape of the magnetic objective 3 from one example may be used in other example, etc.

### Industrial Applicability

A microscope according to this invention may be exploited in all cases where it is necessary to monitor specimens with high resolution and wide field of view, e.g. in the sphere of examination of materials, integrated circuits quality inspection, semiconductor industry, medicine, biology, nano-technology, scientific applications or fundamental research.

## Claims

1. A scanning electron microscope comprising a source of primary electrons, devices to accelerate primary electrons to required kinetic energy, a condenser (2), a magnetic objective (3) with an optical axis, a scanning system for scanning a primary electron beam on a specimen (4) and a secondary electron detector (5), wherein the magnetic objective (3) comprises a first double polepiece lens (3a) having an axial gap and placed on the optical axis at a first working distance (WD1), and a second double polepiece lens (3b) placed on the optical axis at a second working distance (WD2) from the specimen (4) wherein the second working distance (WD2) is greater than the first working distance (WD1), an extraction electrode (7) connected to source of positive voltage to attract secondary electrons into the magnetic objective (3) and the secondary electron detector (5), which is located between this first double polepiece lens (3a) and the second double polepiece lens (3b), **characterized in that** the extraction electrode (7) is located in the first double polepiece lens (3s) such that the extraction electrode (7) partly protrudes into the gap between the polepieces of the first double polepiece lens (3a), and the scanning system is placed between the first double polepiece lens (3a) and the second double polepiece lens (3b).

2. The scanning electron microscope according to the claim 1, wherein bores, following one another, are placed in the polepieces of the first double polepiece lens (3a) and adapted to accommodate the secondary electron detector (5) where the first bore (3c) is placed in an external polepiece and the second bore (3d) is placed in an internal polepiece.

3. The scanning electron microscope according to the claim 2, wherein more bores are placed in the polepieces of the first double polepiece lens (3a) where at least one third bore (3e) is placed in the external polepiece and at least one follow-up fourth bore (3f) is placed in the internal polepiece, and where the third bores (3e) have identical shape and size as the first bore (3c) and their number, including the first bore (3c), is *n* and the fourth bores (3f) have identical shape and size as the second bore (3d) and their number, including the second bore (3d), is *m*, while *n* and *m* are even numbers and all the bores (3c, 3e) in the external polepiece as well as all the bores (3d, 3f) in the internal polepiece are distributed symmetrically around the optical axis of the magnetic objective (3).

4. The scanning electron microscope according to the claim 1, wherein the scanning system (6) is located above the secondary electron detector (5).

5. The scanning electron microscope according to any of claims 1 to 4, wherein at least one retarding electrode (8) is placed above the extraction electrode (7).

6. The scanning electron microscope according to the claim 5, wherein the retarding electrode (8) is connected to a source of low negative voltage.

7. The scanning electron microscope according to the claim 5, wherein the retarding electrode (8) is shaped as an aperture and is grounded.

8. The scanning electron microscope according to the claim 5, wherein a grounded shielding clamp (13) is placed above the retarding electrode (8).

9. The scanning electron microscope according to any of claims 2 to 4, wherein a target (10) with an aperture allowing passing of the primary electrons is placed above a plane of the second bore (3d).

10. The scanning electron microscope according to any of claims 2 to 8, wherein between the extraction electrode (7) and the plane of the second bore (3d) a device (11) is placed, adapted to create crossed magnetic and electrostatic field, advantageously variable, in a direction orthogonal to the optical axis of the magnetic objective (3).

11. The scanning electron microscope according to any of claims 1 to 10, wherein a deflector (12), connected to a source of positive voltage, is placed before the secondary electron detector (5).

12. The scanning electron microscope according to any of claims 3 to 11, wherein a backscattered electron detector and/or cathodoluminescence detector and/or a X-ray detector is placed into at least one pair of the relating third bore (3e) and the fourth bore (3f).

13. The scanning electron microscope according to any of claims 1 to 12, wherein magnetic circuits of the first double polepiece lens (3a) and the second double polepiece lens (3b) are interconnected.

14. The scanning electron microscope according to any of claims 1 to 13, wherein the specimen (4) is connected to a source of negative voltage.

## Patentansprüche

1. Ein Rasterelektronenmikroskop, umfassend eine Primärelektronenquelle, Einrichtungen zur Beschleunigung der Primärelektronen auf die geforderte kinetische Energie, einen Kondensor (2), ein magnetisches Objektiv (3) mit einer optischen Achse, ein Abtastsystem zum Abtasten eines Primärelektronenstrahls auf einer Probe (4) und einen Sekundärelektronendetektor (5), wobei das magnetische Objektiv (3) eine erste Doppelpolschuhlinse (3a) mit einem axialen Spalt, die auf der optischen Achse in einem ersten Arbeitsabstand (WD1) angeordnet ist, und eine zweite Doppelpolschuhlinse (3b), die auf der optischen Achse in einem zweiten Arbeitsabstand (WD2) von der Probe (4) angeordnet ist, wobei der zweite Arbeitsabstand (WD2) größer als der erste Arbeitsabstand (WD1) ist, eine mit einer positiven Spannungsquelle verbundene Extraktionselektrode (7) zum Anziehen der Sekundärelektronen in das magnetische Objektiv (3) und den Sekundärelektronendetektor (5), der zwischen der ersten Doppelpolschuhlinse (3a) und der zweiten Doppelpolschuhlinse (3b) angeordnet ist, aufweist, **dadurch gekennzeichnet, dass** die Extraktionselektrode (7) in der ersten Doppelpolschuhlinse (3a) derart angeordnet ist, dass die Extraktionselektrode (7) teilweise in den Spalt zwischen den Polschuhen der ersten Doppelpolschuhlinse (3a) vorsteht, und das Abtastsystem zwischen der ersten Doppelpolschuhlinse (3a) und der zweiten Doppelpolschuhlinse (3b) angeordnet ist.

2. Das Rasterelektronenmikroskop nach Anspruch 1, wobei in den Polschuhen der ersten Doppelpolschuhlinse (3a) nacheinander Bohrungen angeordnet und zur Aufnahme des Sekundärelektronendetektors (5) ausgebildet sind, wobei die erste Bohrung (3c) in einem externen Polschuh und die zweite Bohrung (3d) in einem inneren Polschuh angeordnet sind.

3. Das Rasterelektronenmikroskop nach Anspruch 2, wobei mehr Bohrungen in den Polschuhen der ersten Doppelpolschuhlinse (3a) angeordnet sind, wobei mindestens eine dritte Bohrung (3e) in dem externen Polschuh angeordnet ist und mindestens eine folgende vierte Bohrung (3f) in dem inneren Polschuh angeordnet ist, und wobei die dritten Bohrungen (3e) eine identische Form und Größe wie die erste Bohrung (3c) aufweisen und ihre Anzahl, einschließlich der ersten Bohrung (3c), *n* ist, und die vierten Bohrungen (3f) eine identische Form und Größe wie die zweite Bohrung (3d) aufweisen und ihre Anzahl, einschließlich der zweiten Bohrung (3d), *m* ist, wobei *n* und *m* gerade Zahlen sind und alle Bohrungen (3c, 3e) im externen Polschuh sowie alle Bohrungen (3d,3f) im inneren Polschuh symmetrisch um die optische Achse des magnetischen Objektivs (3) verteilt sind.

4. Das Rasterelektronenmikroskop nach Anspruch 1, wobei das Abtastsystem (6) über dem Sekundärelektronendetektors (5) angeordnet ist.

5. Das Rasterelektronenmikroskop nach einem der Ansprüche 1 bis 4, wobei über der Extraktionselektrode (7) mindestens eine Verzögerungselektrode (8) angeordnet ist.

6. Das Rasterelektronenmikroskop nach Anspruch 5, wobei die Verzögerungselektrode (8) an einer Quelle mit niedriger negativer Spannung angeschlossen ist.

7. Das Rasterelektronenmikroskop nach Anspruch 5, wobei die Verzögerungselektrode (8) als Apertur geformt und geerdet ist.

8. Das Rasterelektronenmikroskop nach Anspruch 5, wobei über der Verzögerungselektrode (8) eine geerdete Abschirmklemme (13) angeordnet ist.

9. Das Rasterelektronenmikroskop nach einem der Ansprüche 2 bis 4, wobei ein Target (10) mit einer Apertur, die einen Durchgang der Primärelektronen ermöglicht, über einer Ebene der zweiten Bohrung (3d) angeordnet ist.

10. Das Rasterelektronenmikroskop nach einem der Ansprüche 2 bis 8, wobei zwischen der Extraktionselektrode (7) und der Ebene der zweiten Bohrung (3d) eine Einrichtung (11) angeordnet ist, die dazu angepasst ist, um verschränktes magnetisches und elektrostatisches, vorzugsweise variables Feld, in einer Richtung senkrecht zur optischen Achse des magnetischen Objektivs (3) zu erzeugen.

11. Das Rasterelektronenmikroskop nach einem der Ansprüche 1 bis 10, wobei ein Deflektor (12), der an der positiven Spannungsquelle angeschlossen ist, vor dem Sekundärelektronendetektor (5) angeordnet ist.

12. Das Rasterelektronenmikroskop nach einem der Ansprüche 3 bis 11, wobei ein Detektor zurückgestreuten Elektronen und/oder Kathodolumineszenz-Detektor und/oder ein Röntgendetektor in mindestens einem Paar der entsprechenden dritten Bohrung (3e) und vierten Bohrung (3f) angeordnet ist.

13. Das Rasterelektronenmikroskop nach einem der Ansprüche 1 bis 12, wobei magnetische Umkreise der ersten Doppelpolschuhlinse (3a) und der zweiten Doppelpolschuhlinse (3b) miteinander verbunden sind.

14. Das Rasterelektronenmikroskop nach einem der Ansprüche 1 bis 13, wobei die Probe (4) mit einer negativer Spannungsquelle verbunden ist.

## Revendications

1. Un microscope électronique à balayage comprenant une source d'électrons primaires, des dispositifs pour accélérer des électrons primaires à une énergie cinétique requise, un condenseur (2), un objectif magnétique (3) avec un axe optique, un système de balayage pour balayer un faisceau d'électrons primaires sur un échantillon (4) et un détecteur d'électrons secondaires (5), où l'objectif magnétique (3) comprend une première lentille à deux pièces polaires (3a) ayant un entrefer axial et placée sur l'axe optique à une première distance de travail (WD1), et une deuxième lentille à deux pièces polaires (3b) placée sur l'axe optique à une deuxième distance de travail (WD2) de l'échantillon (4), où la deuxième distance de travail (WD2) est supérieure à la première distance de travail (WD1), une électrode d'extraction (7) reliée à une source de tension positive pour attirer des électrons secondaires dans l'objectif magnétique (3) et le détecteur d'électrons secondaires (5), qui est situé entre ladite première lentille à deux pièces polaires (3a) et la deuxième lentille à deux pièces polaires (3b), **caractérisé en ce que** l'électrode d'extraction (7) est située dans la première lentille à deux pièces polaires (3a) de telle sorte que l'électrode d'extraction (7) au moins en partie fait saillie dans l'entrefer entre les pièces polaires de la première lentille à deux pièces polaires (3a), et le système de balayage est placé entre la première lentille à deux pièces polaires (3a) et la deuxième lentille à deux pièces polaires (3b).

2. Le microscope électronique à balayage selon la revendication 1, où des alésages successifs sont placés dans les pièces polaires de la première lentille à deux pièces polaires (3a) et adaptés pour accommoder le détecteur d'électrons secondaires (5), où le premier alésage (3c) est placé dans une pièce polaire externe et le deuxième alésage (3d) est placé dans une pièce polaire interne.

3. Le microscope électronique à balayage selon la revendication 2, où plusieurs alésages sont placés dans les pièces polaires de la première lentille à deux pièces polaires (3a), où au moins un troisième alésage (3e) est placé dans la pièce polaire externe et au moins un quatrième alésage successif (3f) est placé dans la pièce polaire interne, et où les troisièmes alésages (3e) ont une forme et une taille identiques au premier alésage (3c) et leur nombre, y compris le premier alésage (3c), est *n*, et les quatrièmes alésages (3f) ont une forme et une taille identiques au deuxième alésage (3c) et leur nombre, y compris le deuxième alésage (3d), est *m*, où *n* et *m* sont des nombres pairs et tous les alésages (3c, 3e) dans la pièce polaire externe ainsi que tous les alésages (3d, 3f) dans la pièce polaire interne sont répartis symétriquement autour de l'axe optique de l'objectif magnétique (3).

4. Le microscope électronique à balayage selon la revendication 1, où le système de balayage (6) est situé au-dessus du détecteur d'électrons secondaires (5).

5. Le microscope électronique à balayage selon l'une quelconque des revendications 1 à 4, où au moins une électrode de ralentissement (8) est placée au-dessus de l'électrode d'extraction (7).

6. Le microscope électronique à balayage selon la revendication 5, où l'électrode de ralentissement (8) est reliée à une source de faible tension négative.

7. Le microscope électronique à balayage selon la revendication 5, où l'électrode de ralentissement (8) a une forme d'une ouverture et est mise à la terre.

8. Le microscope électronique à balayage selon la revendication 5, où un colier de blindage (13) mis à la terre est placé au-dessus de l'électrode de ralentissement (8).

9. Le microscope électronique à balayage selon l'une quelconque des revendications 2 à 4, où une cible (10) avec une ouverture permettant le passage des électrons primaires est placée au-dessus d'un plan du deuxième alésage (3d).

10. Le microscope électronique à balayage selon l'une quelconque des revendications 2 à 8, où un dispositif (11) est placé entre l'électrode d'extraction (7) et le plan du deuxième alésage (3d), et adapté pour créer un champ magnétique et électrostatique croisé, avantageusement variable, dans une direction orthogonale à l'axe optique de l'objectif magnétique (3).

11. Le microscope électronique à balayage selon l'une quelconque des revendications 1 à 10, où un déflecteur (12) relié à la source de tension positive, est placé devant le détecteur d'électrons secondaires (5).

12. Le microscope électronique à balayage selon l'une quelconque des revendications 3 à 11, où un déflecteur d'électrons rétrodiffusés et/ou un détecteur de cathodoluminescence et/ou un détecteur de rayons X est inséré dans au moins une paire du troisième alésage (3e) et du quatrième alésage (3f) correspondants.

13. Le microscope électronique à balayage selon l'une quelconque des revendications 1 à 12, où des circuits magnétiques de la première lentille à deux pièces polaires (3a) et de la deuxième lentille à deux pièces polaires (3b) sont reliés entre eux.

14. Le microscope électronique à balayage selon l'une quelconque des revendications 1 à 10, où l'échantillon (4) est relié à une source de tension négative.
